Europäisches Patentamt

European Patent Office

Office européen des brevets

(19)

(11) Publication number: **0 119 780**
**A2**

# (12) EUROPEAN PATENT APPLICATION

(21) Application number: **84301442.4**

(22) Date of filing: **05.03.84**

(51) Int. Cl.³: **B 32 B 15/08**

(30) Priority: 21.03.83 US 477457

(43) Date of publication of application: **26.09.84**
**Bulletin 84/39**

(84) Designated Contracting States: **BE CH DE FR GB IT LI NL SE**

(71) Applicant: **STAUFFER CHEMICAL COMPANY, Westport Connecticut 06880 (US)**

(72) Inventor: **Brady, Charles Antony, Route 14, Box 21, Anderson, SC 29621 (US)**
Inventor: **Panza, Robert Alan, 2700B Laguna Circle, Concord California 94520 (US)**
Inventor: **Glosecki, Andy Mike, 325 El Portal, San Jose California 95119 (US)**
Inventor: **Young, Eric Buck Jong, 221 Westwind Road, Anderson, SC 29621 (US)**

(74) Representative: **Smith, Sydney et al, Elkington and Fife High Holborn House 52/54 High Holborn, London WC1V 6SH (GB)**

(54) Electronic interference shielding laminate.

(57) Electronic interference shielding of electronic apparatus to a substantial degree is accomplished by using, as the shielding element, a delamination resistant and formable polymer/metal foil laminate. It comprises a flame retardant and relatively rigid, yet formable polymer film, an adhesive layer attached to the polymer film, and a metal foil, of less thickness than the thickness of the polymer film, attached to the side of the adhesive layer remote from the side attached from the polymer film.

ELECTRONIC INTERFERENCE SHIELDING LAMINATE

The present invention relates to electronic interference shielding (e.g., electromagnetic interference (EMI) or radiofrequency interference (RFI) shielding of electronic apparatus using a novel laminate as the shielding element.

Various techniques have been used to shield electrical components from electronic intereference. In some cases, plastic articles have been utilized, rather than conventional metal shields. Some of the approaches that have been utilized with plastic enclosures for electronic apparatus include the following: (1) the addition of conducting materials to the plastic; (2) the use of metal-loaded paints for the plastic enclosures; (3) arcsprayed metal coatings on the plastic; (4) vacuum deposition of metals onto the plastic; or (5) electroplating or electroless plating of metals onto the plastic.

Another approach that has been tried is the use of multilayer metal/polymer composites as the shielding element. For example, U.S. Patent Nos. 4,115,619, 4,211,822, and 4,241,129, assigned to Dow Chemical Company, all show laminates in which a soft metal layer is directly bonded to a polymer layer by such processes as electroless plating, electroplating, ion plating or extrusion coating.  Such laminates can be rather expensive to manufacture if the preferred electroless plating process is employed.

Although a variety of other polymer/metal laminates
or products are described in the prior art (e.g., in
U.S. Patent Nos. 3,107,198; 3,660,190; 3,776,805; and
4,125,739), the present invention is not shown or
suggested.

The present invention relates to electronic shielding with a delamination resistant, formable, and fire
retardant polymer/metal foil laminate.  The laminate
comprises:  (a)  an inherently flame retardant, substantially rigid, yet formable, film of polymer; (b)
a layer of adhesive attached to one side of the polymer
film; and (c) a thin metal foil adhesively attached to
the adhesive on the side remote from the polymer.  This
laminate produces a substantial degree of electronic
interference shielding for an electronic part when it
is placed between the part and the electronic interference in blocking relationship thereto.

The laminate used in the present invention comprises a flame retardant and substantially rigid, yet
formable, polymer film layer, preferably formed of a
thermoplastic polymer (such as PVC), an adhesive layer
bonded thereto, and a metal foil layer adhered to the adhesive layer on the side remote from the film layer.

The polymers which can be used in forming the flame retardant and substantially rigid, yet formable, polymer layer used in the laminate of the present invention include flame retardant plastics, or combinations of normally non-flame retardant plastics with appropriate flame retardants, such as: polystyrene, sytrene/acrylonitrile copolymers, acrylate/styrene/ acrylonitrile polymers, ABS polymers, polycarbonate (e.g., LEXAN brand), polyester resins, acrylic resins, polyamide resins, polyolefins and polyvinyl halide. For high temperature applications, the polymer chosen should have an appropriately high heat distortion temperature. Preferred is polyvinyl chloride for its low cost and flame retardancy characteristics. The thickness of the polymer film can range from 10 mils (0.254 mm) to 1/8 inch (3.17 mm). If the polymer chosen is not inherently flame retardant, such as vinyl chloride polymer, an effective amount of flame retardant (e.g., from about 1% to about 30%) needs to be used. If desired, impact resistant grades of such polymers can be utilized.

The polymer layer used in the laminate of the present invention has a thickness which is greater than the thickness of either the adhesive or metal foil. It serves as the main support component of the laminate and has a substantial degree of rigidity so the laminate will have a sufficient degree of strength for the intended purpose, e.g., as a self-standing enclosure over an electronic part to serve as a source shield. The polymer layer, while of a sufficient degree of rigidity, is also of a sufficient degree of flame retardancy to confer an inherent flame retardant character upon the laminate as a whole. Preferably, the laminate satisfies a UL-94 VO flammability rating. The polymer chosen to form the film can be of a cost which renders the laminate less expensive than shields formed of metal. The polymer component of the present laminate, since it is its main support element, is formable so that it can be easily scored, bent or otherwise formed (e.g., by pressure forming and/or thermoforming techniques) so that the desired geometric forms can be obtained. Finally, the presence of the polymer layer provides a dielectric component adjacent the electric part to be shielded which reduces the risk of shorting of the circuit board containing the part.

The adhesive layer used to securely bond the polymer film and metal foil is disposed between those two components and can have a thickness of from 0.05 mils (0.00127 mm) to 2 mils (0.058 mm). The type of adhesive chosen should insure good bonding strength between the particular polymer layer and metal foil chosen for use in the laminate. Exemplary types of adhesive that can be used include: polyvinyl acetate-maleate copolymer, polyurethane, polyester type, butadiene/acrylonitrile copolymers, vinyl chloride/vinyl acetate copolymers, methyl methacrylate/glycidyl methacrylate copolymers, and epoxy resins. If desired, the adhesive can be of a conductive nature to provide extra shielding.

The metal foil layer (which is of relatively thinner configuration than the polymer layer) can be chosen from a variety of conductive metals and should be of a sufficient degree of thickness to produce the desired substantial attenuation of the interference, e.g., at

- 5 -

least 30 db. Thicknesses of from 0.25 mil (0.00635 mm) to 8 mils (0.2032 mm) can be used. If desired, more than one metal foil can be used to constitute the metal layer, e.g., bonded by suitable conductive or non-conductive adhesive. Exemplary metals include aluminum, iron and steel, zinc, nickel, tin and copper, or alloys of metals which will form a shield against electronic interference.

Optionally, the laminates of the present invention can contain a layer of pressure sensitive adhesive on the side of the polymer film remote from the side attached to the metal foil via the adhesive layer. This layer of adhesive allows for bonding of the electronic interference shielding element of the present invention to a desired substrate. If desired, the pressure sensitive adhesive layer can have its exposed surface covered by a release liner to protect it from contamination by dirt or other foreign matter. As used herein the term "foil" is intended to cover self-supporting metal layers which are either continuous metal layers, as preferred, or are in the form of a screen mesh. The type of metal selected will influence the range of frequencies that are attenuated, e.g., ferromagnetic for low frequencies and aluminum for high frequencies.

The laminate of the present invention can be made using conventional laminating and coating techniques. For example, the adhesive layer of choice can be applied to one surface of the polymer film of choice and the desired metal foil can be laminated to the exposed surface of the adhesive using a sufficient degree of heat and/or pressure to bond the foil to the adhesive.

C-6998

The laminates of the present invention serve as an effective electronic interference shield. For example, they can be formed into a configuration that can be placed around a source of electronic interference so as to function as a "source shield" by effectively blocking an acceptable degree of interference emanating from the source. They can also be used as a shielding element around electronic parts to protect those parts from electronic interference exterior to the parts. The laminates of the present invention can be less costly than shields formed of metal. They also can be easier to fabricate into nonplanar forms due to the presence of the relatively thick polymer which confers a degree of support, yet formability, on the laminate not inherent in metal shields. The present laminates, by use of either inherently flame retardant polymers (e.g., PVC) or by mixing appropriate levels of flame retardant with formable, yet substantially rigid polymers, confers desired flame retardancy on the shielding element formed from the laminate.

The present laminates can be used as shielding elements in various ways. They can be affixed to the interior surfaces of plastic enclosures of electronic equipment (e.g., by appropriate mechanical fasteners or adhesive) to shield the electronic circuitry contained inside the enclosure from outside interference. The laminates can also be formed into appropriate geometrical shapes (e.g., by scoring of a flat laminate form followed by bending along the scored lines) so as to appropriately surround a source of electronic interference and serve as a "source shield". In any case, the present laminates provide a structure which is

C-6998

formable, flame retardant and inexpensive for the shielding of electronic parts from the effects of electronic interference.

The present invention is further illustrated by the following Example which illustrates certain embodiments of the present invention.

- 8 -

## EXAMPLE

This Example illustrates several embodiments of the present invention.

The ingredients listed below were mixed together to form an adhesive composition for use in making the desired laminate.

| Ingredient | Parts by Weight |
| --- | --- |
| Polyvinylacetate-maleate copolymer* | 79.2 |
| Plasticizer** | 8.7 |
| 3,4-epoxy cyclohexylmethyl-3,4-epoxy-cyclohexane carboxylate*** | 1.7 |
| Tin octoate [+] | 0.27 |
| Isopropyl Alcohol | 45.83 |
| Water | 8.9 |

*GELVA Multipolymer Solution 264 from Monsanto Co.

**SANTICIZER 141 brand from Monsanto Co.

***ERL-4221 brand from Union Carbide Corp.

[+]FOMREZ C-2 brand from Witco Chemical

The adhesive composition described above was used to make a series of samples of laminates in accordance with the present invention:

Sample 1

The above adhesive was applied to a relatively rigid PVC film (VCH-5001 from Nuodex) which had a thickness of 20 mils (0.58 mm), using a gravure roll and the resulting structure was laminated to 1.5 mil (0.0381 mm) thick aluminum alloy (1145 Alloy-0 Temper). The laminate was then hot nipped at 300°F (149°C) at a rate of 30 feet (9.14 metres) per minute.

C-6998

Samples 2-4

In the fabrication of each of these samples, 21 mil (0.533 mm) PVC film (Nuodex VCH-5001) was laminated, using the above adhesive, to each of the following three metal foil constructions to form each respective sample:

a) aluminum alloy foil (3 mil (0.076 mm) thickness) bonded by ethylene acrylic acid adhesive to aluminum alloy foil (3 mil (0.076 mm) thickness);

b) aluminum alloy (3 mil (0.076 mm) thickness); and

c) aluminum alloy (4 mil (10.16 mm) thickness). The resulting laminates all had their exposed plastic film surface laminated with 1 mil of pressure sensitive adehsive (National Starch 72-9297 brand).

Samples 5-6

These samples were made by laminating 1.5 mil (0.0381 mm) and 1.0 mil (0.0254 mm) aluminum alloy foil by means of the above adhesive to 20 mil (0.508 mm) PVC film (VCH 5001-21 brand from Nuodex).

In all of the sample preparations continuous metal foil was used. The amount of adhesive applied to the PVC film to make each of the above samples was approximately 3 lbs (1.36 kg) per ream (3000 $ft^2$ (278 $m^2$)).

CLAIMS:

1.    A delamination resistant, formable, fire retardant laminate useful in electronic interference shielding of an electronic part which comprises:

(a) a flame retardant and relatively rigid, yet formable, polymer film;

(b) a layer of adhesive attached to one side of the film of the polymer;  and

(c) a metal foil, of less thickness than the thickness of the polymer film, adhesively attached to the adhesive on the side remote from the polymer to produce a substantial degree of electronic interference shielding for an electronic part when the laminate is placed between the part and electronic interference in blocking relationship thereto.

2.    A laminate as claimed in claim 1 characterised in that the polymer film has a thickness of from 10 mils to 1/8 inch (0.254-3.17 mm).

3.    A laminate as claimed in claim 1 or claim 2 characterised in that the polymer film contains polyvinyl chloride.

4.    A laminate as claimed in any of claims 1 to 3 characterised in that the adhesive layer has a thickness of from 0.05 mil to 2 mils (0.00127-0.058 mm).

5.    A laminate as claimed in any of claims 1 to 4 characterised in that the adhesive is a polyvinyl acetate-maleate copolymer.

6.    A laminate as claimed in claim 1 wherein the metal foil has a thickness of from 0.25 to 8 mils (0.00635 - 0.2032 mm).

7.    A laminate as claimed in any of claims 1 to 6 characterised in that the metal foil comprises aluminum.

8.    A laminate as claimed in any of claims 1 to 7 characterised in that it further comprises a layer of pressure sensitive adhesive on the polymer film on a side remote from the side containing adhesive layer (b).

9.    A laminate as claimed in claim 8 characterised in that a release liner covers a surface of the pressure sensitive adhesive to protect it from contamination.

10.    A method of shielding an electronic part from a substantial degree of electronic interference which comprises placing a delamination resistant, formable, and fire retardant laminate as claimed in any of claims 1 to 9 between the part and the electronic interferences.